# EUROPEAN PATENT APPLICATION

(11) **EP 1 369 918 A2**
(43) Date of publication of application: **10.12.2003**
(21) Application number: 02255524.7
(22) Date of filing: 07.08.2002
(51) Int. Cl.: H01L 23/427, H01L 23/367, H01L 23/373, C09K 5/14, G06F 1/20, H05K 7/20, F28F 13/00

(54) **Heat transfer device with thermal superconducting heat transfer layer**

(30) Priority: 03.06.2002 CN 02236901 U
(71) Applicant: Orra Corporation, Santa Clara, San Diego, CA 95054 (US)
(72) Inventor: Luo, Chin-Kuang, Taichung City (TW)
(74) Representative: Hector, Annabel Mary

(57) **Abstract**

A heat transfer device includes a thermal superconducting body (5), which has a hollow heat transfer body (55) and a heat transfer layer (57). The hollow heat transfer body (55) is made of a heat conductive material and has a flat top portion (52) and a flat bottom portion (51) connected to the flat top portion (52) and cooperating with the flat top portion (52) to form a sealed vacuum receiving space (56) therebetween. The heat transfer layer (57) is made of a thermal superconductor material, is disposed in the vacuum receiving space (56), and forms a superconductor lining on an inner wall surface (54) of the heat transfer body(55).

## Description

This application claims priority of China application No. 02236901.5, filed on June 3, 2002.

The invention relates to a heat transfer device, more particularly to a heat transfer device capable of rapidly and efficiently transferring heat.

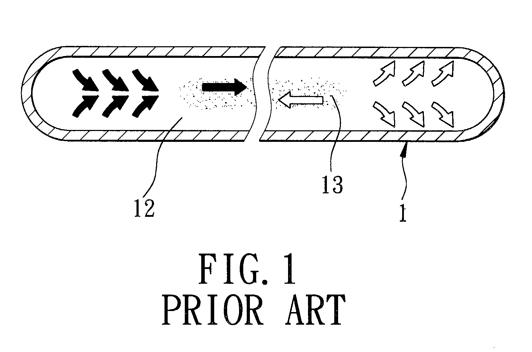

Referring to Figure 1, a conventional heat pipe 1 used for heat transfer includes a sealed metal tube 12 and a work fluid 13 contained therein. Heat is absorbed at one end by vaporization of the work fluid 13 and is released at the other end by condensation of the vapor of the work fluid 13 . However, the heat conducting speed of the heat pipe 1 is limited by the amount of latent heat of liquid vaporization and by the speed of the change state of the work fluid 13. Moreover, the heat pipe 1 suffers from thermal losses, which further reduce the thermal efficiency.

Additionally, in a conventional portable electronic device, the amount of heat released by a heat source, such as a central processing unit (CPU) of the device, increases with the increase in the functions and the processing speed of the device. Therefore, conventional heat transfer devices, such as the aforesaid heat pipe, can not be utilized for efficiently removing heat from the electronic device.

Therefore, an object of the present invention is to provide a heat transfer device capable of rapidly and efficiently transferring heat.

The heat transfer device according to this invention includes a thermal superconducting body, which has a hollow heat transfer body and a heat transfer layer.

The hollow heat transfer body is made of a heat conductive material and has a flat top portion and a flat bottom portion connected to the flat top portion and cooperating with the flat top portion to form a sealed vacuum receiving space therebetween.

The heat transfer layer is made of a thermal superconductor material, is disposed in the vacuum receiving space, and forms a superconductor lining on an inner wall surface of the heat transfer body.

Other features and advantages of the present invention will become apparent in the following detailed description of the preferred embodiment with reference to the accompanying drawings, of which:
Figure 1 is a fragmentary sectional view of a conventional heat pipe;
Figure 2 is a schematic block diagram of the preferred embodiment of a heat transfer device according to this invention;
Figure 3 is a schematic view of the preferred embodiment in a state of use;
Figure 4 is a perspective view of the preferred embodiment;
Figure 5 is a sectional view of the preferred embodiment;
Figure 6 is a perspective view of a portable computer which includes the preferred embodiment of the heat transfer device according to this invention; and
Figure 7 is a partially enlarged perspective view of the portable computer.

Before the present invention is described in greater detail, it should be noted that like elements are denoted by the same reference numerals throughout the disclosure.

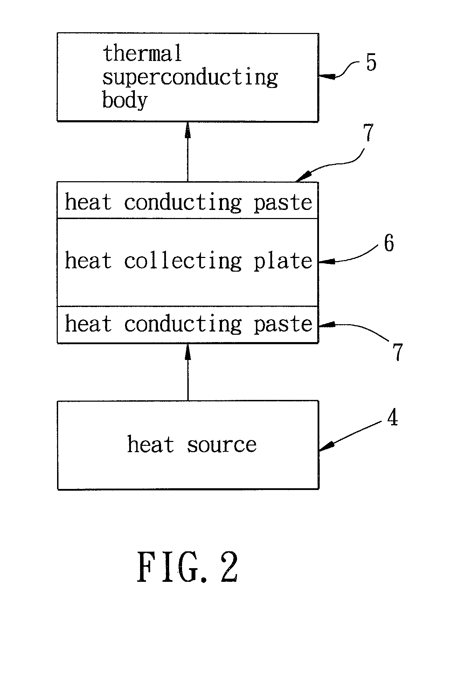

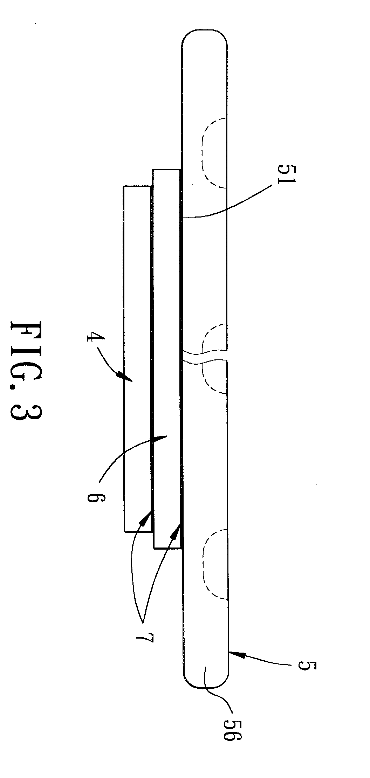

Referring to Figures 2 and 3, the preferred embodiment of a heat transfer device according to this invention is shown to include a thermal superconducting body 5, a heat collecting plate 6, and heat conducting paste 7, and is mounted on a heat source 4, such as a central processing unit (CPU), an integrated circuit (IC), and the like.

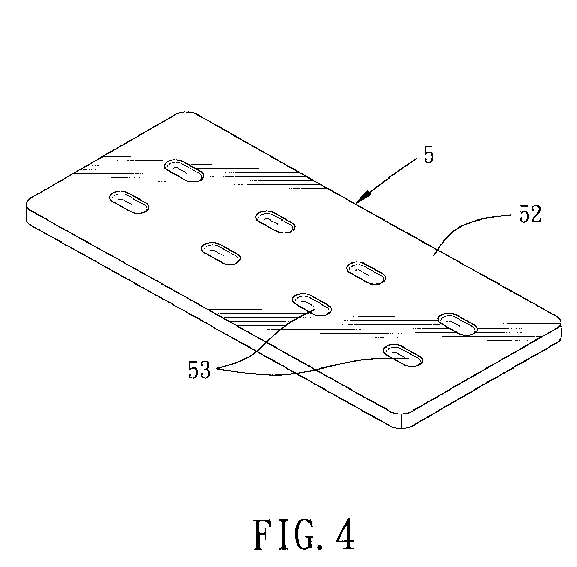

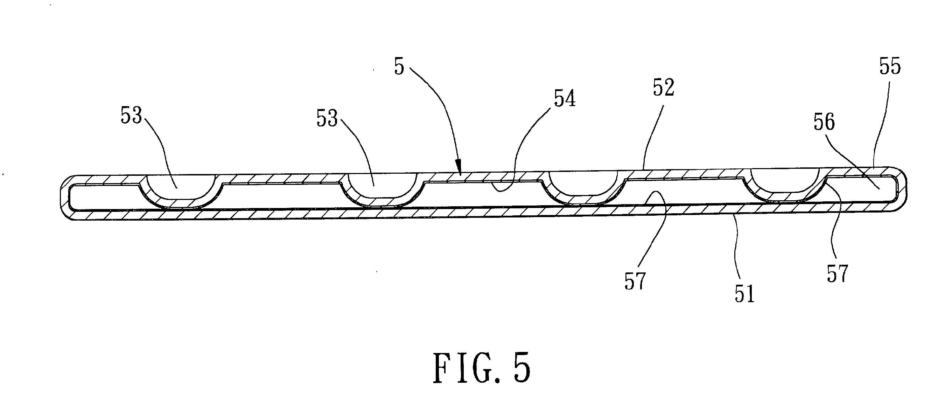

Referring to Figure 4 and 5, the thermal superconducting body 5 includes a hollow heat transfer body 55 and a heat transfer layer 57. The hollow heat transfer body 55 is made of a heat conductive material, such as aluminum, copper, or a metal alloy, or a material which exhibits excellent heat conducting characteristics, such as ceramics, glass, graphite, or thermal conductive plastic. The hollow heat transfer body 55 can be formed in any suitable shape, and has a flat top portion 52 and a flat bottom portion 51 connected to the flat top portion 52 and cooperating with the flat top portion 52 to form a sealed vacuum receiving space 56 therebetween. The flat top portion 52 is formed with a plurality of recesses 53, each of which has a bottom that extends to and that is in contact with the flat bottom portion 51.

The heat transfer layer 57 is made of a thermal superconductor material, is disposed in the vacuum receiving space 56, and forms a superconductor lining on an inner wall surface 54 of the heat transfer body 55.

It is noted that the thermal superconductor material includes at least one compound selected from the group consisting of sodium peroxide, sodium oxide, beryllium oxide, manganese sesquioxide, aluminum dichromate, calcium dichromate, boron oxide, dichromate radical, and combinations thereof; at least one compound selected from the group consisting of cobaltous oxide, manganese sesquioxide, beryllium oxide, strontium chromate, strontium carbonate, rhodium oxide, cupric oxide, β-titanium, potassium dichromate, boron oxide, calcium dichromate, manganese dichromate, aluminum dichromate, dichromate radical, and combinations thereof; and at least one compound selected from the group consisting of denatured rhodium oxide, potassium dichromate, denatured radium oxide, sodium dichromate, silver dichromate, monocrystalline silicon, beryllium oxide, strontium chromate, boron oxide, sodium peroxide, β -titanium, a metal dichromate, and combinations thereof.

Referring again to Figure 3, the heat collecting plate 6 is mounted on the flat bottom portion 51 externally of the vacuum receiving space 56. The heat collecting plate 6 has opposite surfaces, each of which is coated with the heat conducting paste 7. The heat collecting plate 6 is made of a thermal conductive metal, such as copper and aluminum.

In actual practice, the inner wall surface 54 of the heat transfer body 55 is passivated, washed and dried. The thermal superconductor material is then injected or filled into the hollow heat transfer body 55, which is then vacuumed and sealed so as to form the superconductor lining on the inner wall surface 54 of the heat transfer body 55.

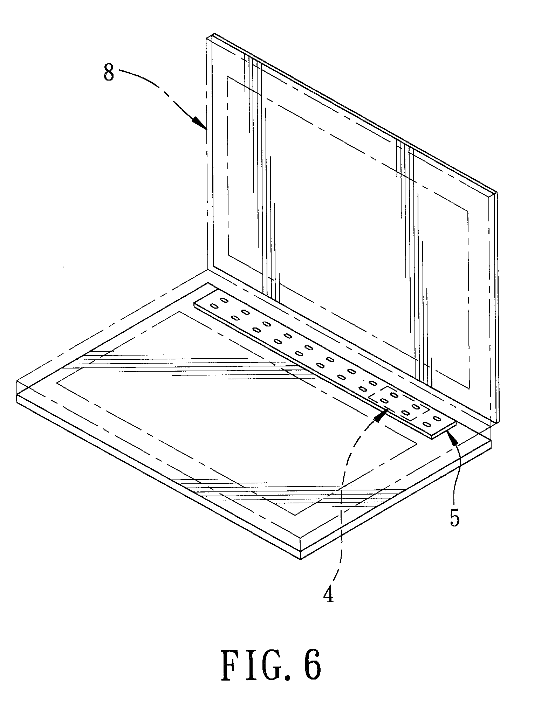

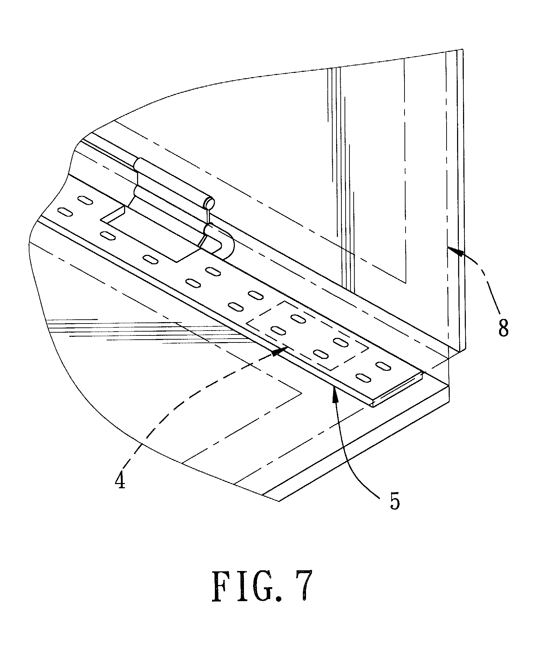

In use, referring to Figures 6 and 7, the thermal superconducting body 5 of the preferred embodiment of the heat transfer device according the present invention is shown to be mounted on a portable computer 8 for transferring heat from the heat source 4 (such as CPU) of the portable computer 8.

The advantages of the heat transfer device of the present invention are as follows:
1. Rapid and efficient transfer of heat can be achieved due to the high heat conducting coefficient of the thermal superconductor material used for the heat transfer layer of the heat transfer device of the present invention.
2. The configuration of the heat transfer device of the present invention is more flexible than that of the aforesaid conventional heat pipe.

## Claims

1. A heat transfer device, **characterized by**:
a thermal superconducting body (5) including
a hollow heat transfer body (55) made of a heat conductive material and having a flat top portion (52) and a flat bottom portion (51) connected to said flat top portion (52) and cooperating with said flat top portion (52) to form a sealed vacuum receiving space (56) therebetween; and
a heat transfer layer (57) made of a thermal superconductor material, disposed in said vacuum receiving space (56), and forming a superconductor lining on an inner wall surface (54) of said heat transfer body (55).

2. The heat transfer device as claimed in Claim 1, **characterized in that** said flat top portion (52) is formed with a plurality of recesses (53) , each of which has a bottom that extends to and that is in contact with said flat bottom portion (51).

3. The heat transfer device as claimed in Claim 1 or 2, further **characterized by** a heat collecting plate (6) mounted on said flat bottom portion (51) externally of said vacuum receiving space (56).

4. The heat transfer device as claimed in Claim 3, **characterized in that** said heat collecting plate (6) has opposite surfaces, each of which is coated with heat conducting paste (7).

5. The heat transfer device as claimed in Claim 3 or 4, **characterized in that** said heat collecting plate (6) is made of thermal conductive metal selected from a group consisting of copper and aluminum.

6. The heat transfer device as claimed in any preceding claim, **characterized in that** said thermal superconductor material includes at least one compound selected from the group consisting of sodium peroxide, sodium oxide, beryllium oxide, manganese sesquioxide, aluminum dichromate, calcium dichromate, boron oxide, dichromate radical, and combinations thereof; at least one compound selected from the group consisting of cobaltous oxide, manganese sesquioxide, beryllium oxide, strontium chromate, strontium carbonate, rhodium oxide, cupric oxide, β-titanium, potassium dichromate, boron oxide, calcium dichromate, manganese dichromate, aluminum dichromate, dichromate radical, and combinations thereof; and at least one compound selected from the group consisting of denatured rhodium oxide, potassium dichromate, denatured radium oxide, sodium dichromate, silver dichromate, monocrystalline silicon, beryllium oxide, strontium chromate, boron oxide, sodium peroxide, β -titanium, a metal dichromate, and combinations thereof.

7. The heat transfer device as claimed in any preceding claim, **characterized in that** said heat conductive material for said hollow heat transfer body (55) is selected from a group consisting of aluminum, copper, metal alloy, ceramics, glass, graphite, and thermal conductive plastic.
